# EUROPEAN PATENT APPLICATION

(11) **EP 2 368 646 A2**
(43) Date of publication of application: **28.09.2011**
(21) Application number: 11158396.9
(22) Date of filing: 16.03.2011
(51) Int. Cl.: B08B 5/02, B08B 15/04

(54) **Air dust collector**

(30) Priority: 26.03.2010 JP 2010072481
(71) Applicant: Mitsuboshi Diamond Industrial Co., Ltd., Suita-city, Osaka 564-0044 (JP)
(72) Inventor: Hirono, Yoshifumi, Suita City, Osaka 564-0044 (JP)
(74) Representative: TBK

(57) **Abstract**

Provided is a device capable of removing dust from a substrate surface with a simple and inexpensive configuration, and efficiently aspirating and disposing of the removed dust. The air dust collector is a device for removing dust from a substrate surface with air, having an air intake part (1) from where air is introduced, an ejector part (2), and a discharge part (3). The ejector part (2) increases the flow rate of the air from the air intake part (1) and blows the air onto the substrate surface. The discharge part (3) aspirates and discharges the air that has been blown out from the ejector part (2), as well as ambient air. The air pressure at the substrate surface is made lower than the ambient atmospheric pressure by the ejector effect produced by the air flowing from the ejector part (2) to the discharge part (3).

## Description

### BACKGROUND OF THE INVENTION

### Field of the Invention

The present invention relates to an air dust collector, particularly an air dust collector for removing dust from the surface of a substrate or other workpieces, with air.

### Description of the Related Art

In the layered substrates of solar batteries and the like, thin films such as metal films and/or semiconductor films are layered on a glass substrate. These thin films are then provided with a plurality of isolation trenches for insulation treatment. These isolation trenches are formed by laser heads using laser beams and/or by mechanical tools using diamond blade tips or the like.

During the formation of trenches in such thin films, portions of films that are removed from the substrate adhere to the substrate in the form of dust or other foreign matter. Because such foreign matter can cause defects, the foreign matter must be removed from the substrate.

Conventionally, devices such as the one disclosed in Japanese Laid-open Patent Publication No, 2003-200121, for example, have been proposed as devices for the removal of dust and other foreign matter from such substrates. The device disclosed in Japanese Laid-open Patent Publication No, 2003-200121 blows compressed air onto the surface of a substrate or other workpieces to remove dust that has adhered to the workpiece surface.

Specifically, the device disclosed in Japanese Laid-open Patent Publication No, 2003-200121 has an air cleaning head, an ultrasound oscillation controller, and two ultrasound generators. The air cleaning head has a pressure chamber fed with compressed air, and a negative-pressure chamber for aspirating blown compressed air together with dust. The pressure chamber is provided with two pressure compartments that are in communication with one another, and the ultrasound generators are provided on these two pressure compartments. The two pressure compartments are also provided with a pair of blow nozzles for blowing ultrasonic air.

In such devices, high-speed ultrasonic air is blown from the pair of blow nozzles against a workpiece surface. The dust is then aspirated along with the air into the negative-pressure chamber through a dust aspiration port provided to the negative-pressure chamber.

### SUMMARY OF THE INVENTION

With the device disclosed in Japanese Laid-open Patent Publication No, 2003-200121, the ultrasound generators and ultrasound oscillation controller are necessary in addition to the air cleaning head, and the device becomes expensive. Furthermore, dust that has adhered to a workpiece surface can be removed by blowing ultrasonic air at a high speed onto the workpiece surface, but it is difficult to efficiently aspirate the removed dust into the negative-pressure compartment. For this reason, the dust that has been removed may re-adhere to the workpiece surface.

An object of the present invention is to provide a device that allows the dust on a workpiece surface to be removed using a simple and inexpensive configuration, and the removed dust to be efficiently aspirated and discharged.

The air dust collector according to a first aspect is an air dust collector for removing dust from a workpiece surface with air, having an air intake part from where air is introduced, an ejector part, and a discharge part. The ejector part increases the flow rate of the air from the air intake part and blows the air onto the workpiece surface. The discharge part aspirates and discharges the air that has been blown out from the ejector part, as well as ambient air. The air pressure at the workpiece surface is made lower than the ambient atmospheric pressure by the ejector effect produced by the air flowing from the ejector part to the discharge part.

With this device, air is introduced from the outside through the air intake part. The introduced air is caused to achieve a higher flow rate by the ejector part and is blown onto the workpiece surface. At this time, ejector effect is generated by the air flowing from the ejector part to the discharge part, and the air pressure in the vicinity of the workpiece surface becomes lower than the ambient atmospheric pressure. Because of this, air from the ejector part, as well as ambient air, flows onto the workpiece surface, and the dust from the workpiece surface is removed by this air flow. The dust removed from the workpiece surface is then aspirated into the discharge part together with the air, and is discharged..

Here, dust on the workpiece surface can be removed using a simple and inexpensive configuration. Furthermore, air and dust can be aspirated and discharged efficiently compared with the blowing of high-speed air onto a workpiece surface as with conventional devices.

The air dust collector according to a second aspect is the device according to the first aspect wherein the ejector part brings the air pressure at the workpiece surface to a negative pressure to an extent that the workpiece is not lifted up.

In this arrangement, excessively lowering the air pressure in the vicinity of the workpiece surface by the ejector effect may cause the workpiece to be lifted up from the table or other mounting part. If the workpiece is lifted up, the position of the workpiece will be shifted and processing errors will occur.

In view of this, in the invention according to the second aspect, the extent of the negative pressure on the workpiece surface is adjusted. For this reason, the workpiece will not be lifted up, and processing errors caused by positional shifting of the workpiece can be prevented.

The air dust collector according to a third aspect is the device according to either the first aspect or the second aspect, wherein the air intake part has a pair of air intake ports positioned opposite each other, with the discharge part interposed in between. Furthermore, the ejector part has a pair of constricted parts and a pair of air outflow parts. The pair of constricted parts is positioned opposite each other, with the discharge part interposed in between, on the downstream side of an airflow pathway from the air intake ports, and increases the flow rate of the air from the air intake ports. The pair of air outflow parts is positioned on the downstream side of an airflow pathway from the pair of constricted parts.

Here, air is introduced through the pair of oppositely positioned air intake ports, and air from the two air outflow parts is blown onto the workpiece surface. Furthermore, the discharge part is positioned between these parts. Air can therefore be blown onto the workpiece surface efficiently, and air and dust can be removed and discharged efficiently as well.

The air dust collector according to a fourth aspect is the device according to the third aspect, wherein the discharge part has a pair of discharging plate members provided with an internally disposed discharge compartment, and an aspiration port in communication with the discharge compartment at a lower end thereof. Furthermore, the ejector part has a pair of ejector plate members respectively mounted on the outside of the pair of discharging plate members and arranged to form the constricted parts and the air outflow parts between the two discharging plate members. The device is further provided with a shim disposed between the pair of discharging plate members and the pair of ejector plate members, for adjusting the cross-sectional area of the airflow pathway of the constricted parts.

Here, the ejector part and the discharge part can have a simple configuration and are easy to assemble and disassemble. Furthermore, because a shim is provided between the ejector plate members and the discharging plate members, the cross-sectional area (constriction diameter) of the airflow pathway of the constricted part of the ejector part can be adjusted by the shim, and the pressure of the air at the workpiece surface can easily be adjusted to an appropriate pressure.

With the present invention as described above, dust on a workpiece surface can be removed using a simple and inexpensive configuration. Furthermore, the removed dust can be efficiently aspirated and discharged.

### BRIEF DESCRIPTION OF THE DRAWINGS

Fig. 1 is an external perspective view of an air dust collector according to an embodiment of the present invention.
Fig. 2 is a cross-sectional view of the air dust collector.

### DETAILED DESCRIPTION OF THE INVENTION

### [Overall Configuration]

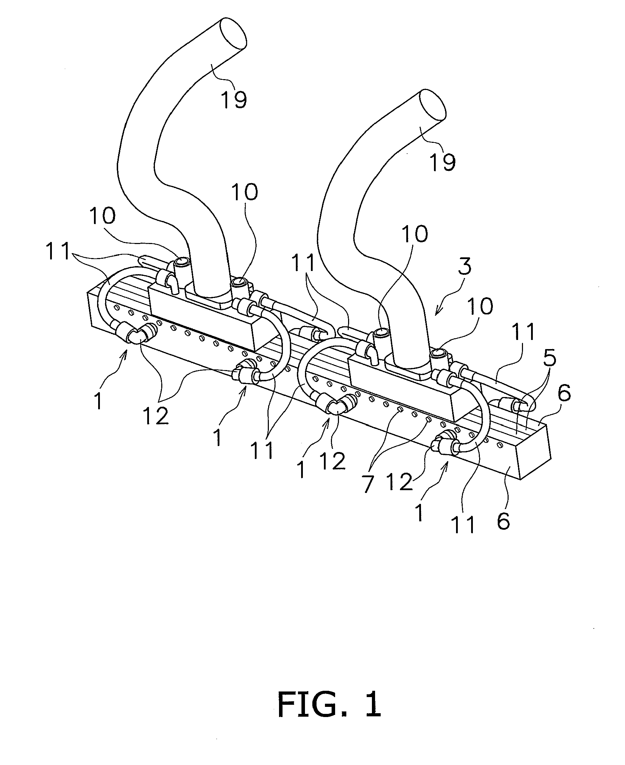

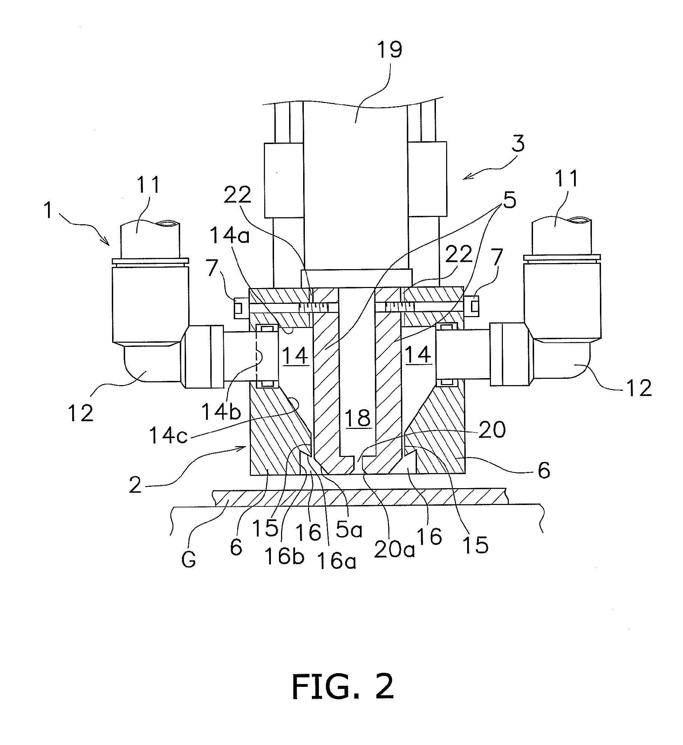

Fig. 1 is an external perspective view of an air dust collector according to an embodiment of the present invention, and Fig. 2 is a cross-sectional view thereof. This air dust collector is a device used to remove dust that has adhered to a substrate surface during patterning of a substrate for a solar battery, for example.

This device has a plurality of air intake parts 1, an ejector part 2, and a discharge part 3. The discharge part 3 is configured with a pair of discharging plate members 5 positioned opposite each other. The ejector part 2 is also configured with the pair of discharging plate members 5 and a pair of ejector plate members 6. The pair of ejector plate members 6 are each fixed to the outside of the pair of discharging plate members 5 through a plurality of bolts 7. As is made apparent in Fig. 1, each of the plate members 5, 6 is formed into a strip that extends in one direction.

### [Air Intake Part]

The air intake part 1 has a plurality of supply pipes 10 and a pair of intake pipes 11 arranged to connect to the plurality of supply pipes 10. The plurality of supply pipes 10 are connected to a compressor or other air supply sources (not shown). Each of the pair of intake pipes 11 is arranged to branch out from one supply pipe 10, and a joint (air intake port) 12 is provided at the tip thereof. Each of the joints 12 is mounted to a pair of ejector plate members 6. Air is introduced from both sides of the discharge part 3 by such a configuration.

### [Ejector Part]

The ejector part 2 has a pair of air intake compartments 14, a pair of constricted parts 15, and a pair of air outflow parts 16, each positioned opposite each other, with the discharge part 3 interposed in between. The ejector part 2 is the part for increasing the flow rate of the air from the air intake part and blowing the air onto the surface of the substrate G. Ejector effect is achieved through the flow of air from this ejector part 2 to the discharge part 3, and the pressure at the substrate surface is brought to a negative pressure that is lower than the ambient atmospheric pressure. Furthermore, the pressure at the substrate surface is controlled and brought to a negative pressure to the extent that the substrate G is not lifted up.

Because the ejector part 2 is formed symmetrically about the discharge part 3, only the configuration for one side will be described below.

The ejector part 2 is configured with a discharging plate member 5 and an ejector plate member 6. Specifically, on the side opposite the discharging plate member 5, the ejector plate member 6 has an upper recess that forms an air intake chamber 14 and a lower recess that forms an air outflow part 16.

The upper recess is formed from the top part of the ejector plate member 6, through a vertically central part, and into the lower part thereof, and has a top wall 14a, a side wall 14b, and a top diagonal wall 14c. The top wall 14a is formed horizontally. The side wall 14b is formed vertically, and the joint 12 of the air intake part 1 is connected to this side wall 14b. The top diagonal wall 14c extends downward from the bottom edge of the side wall 14b, and is sloped so as to approach the discharging plate member 5 as the wall extends.

The lower recess is formed at the bottom part of the ejector plate member 6. This lower recess has a lower diagonal wall 16a and a side wall 16b, and is open at the bottom. The lower diagonal wall 16a forms the top of the lower recess, and is sloped upward as the wall extends away from the discharging plate member 5. Furthermore, the portion of the discharging plate member 5 opposite the lower recess has an outside diagonal part 5a that slopes inward as the part extends downward. Furthermore, the side wall 16b is formed vertically. The air outflow part 16 is configured with such a lower recess and an outside diagonal part 5a of the discharging plate member such as these. With such a configuration, the air that passes through the below-described constricted part 15 and flows into the air outflow part 16 flows inwards along the outside diagonal part 5a, and does not flow outwards along the lower diagonal wall 16a. It is therefore possible to prevent air that flows into the air outflow part 16 from flowing out of the air dust collector and prevent dust from scattering as a result thereof.

The constricted part 15 is formed between the upper recess (air intake compartment 14) and the lower recess (air outflow part 16). This constricted part 15 is a predetermined gap formed between the inside end face of the ejector plate member 6 and the outside end face of the discharging plate member 5, and has a predetermined vertical length. The air that flows from the air intake compartment 14 achieves a high flow rate by passing through this constricted part 15, and ejector effect is generated at the portion extending from the air outflow part 16 to the discharge part 3.

### [Discharge Part]

The discharge part 3 is for aspirating and discharging the air from the ejector part 2 and the ambient air. The discharge part 3, as previously described, is configured with the pair of discharging plate members 5 opposite each other, and is configured with a discharge compartment 18 between the two discharging plate members 5. Furthermore, a plurality of discharge pipes 19 are connected to this discharge compartment 18. As is made apparent in Fig. 1, the plurality of discharge pipes 19 are positioned at predetermined intervals along the longitudinal direction. Furthermore, a discharging aspiration port 20 is formed at the bottom part of the discharge compartment 18. A pair of inside diagonal parts 20a that are sloped so as to widen outwards as the parts extend downward is formed at the bottom end of the discharging aspiration port 20. The inflow of air into the discharge compartment 18 from the outside is made easier by this inside diagonal part 20a.

### [Shim]

A shim 22 is inserted in the top portion between the ejector plate member 6 and the discharging plate member 5. The constriction diameter of the constricted part 15, in other words, the cross-sectional area of the airflow pathway, can be adjusted by adjusting the thickness or the number of the shims 22. By adjusting the constriction diameter of the constricted part 15 and the pressure of the air being fed into the air intake part 1, the negative pressure from the ejector effect at the substrate surface can be adjusted and brought to the level at which the substrate G positioned below the device is not lifted up.

### [Operation]

When air is introduced into the air intake part 1 via the supply pipes 10, the air flows into the ejector part 2 via the joints 12. In the ejector part 2, the air first flows into the air intake compartment 14 and then into the air outflow part 16 through the constricted part 15. At this point, the air flowing out of the constricted part 15 achieves a high flow rate and flows past the substrate surface toward the discharging aspiration port 20 of the discharge part 3. The substrate surface acquires a negative pressure that is lower than the ambient atmospheric pressure due to such a flow of air. Ambient air is drawn in by the airflow into the discharging aspiration port 20 of the discharge part 3 due to this negative pressure and the viscosity of air. The dust adhering to the substrate surface is drawn into the aspiration port 20 of the discharge part 3 along with the air and caused to flow into the discharge compartment 18 of the discharge part 3 by such an ejector effect. After that, the dust is discharged to the outside via the discharge pipes 19.

### [Characteristics]

(1) Because dust is drawn into the discharge part 3 along with the ambient air by ejector effect rather than being blown away by blowing air on a substrate surface, the dust can be removed and discharged efficiently.
(2) Because the constriction diameter of the constricted part 15 of the ejector part 2 (cross-sectional area of the airflow pathway) can be easily adjusted through a shim 22, an optimal ejector effect can be readily attained.
(3) Because the air outflow parts 16 of the ejector part 2 are positioned opposite each other with the discharge part 3 interposed in between, dust on the substrate surface can be removed and discharged more efficiently.
(4) The primary components of the device can be realized by a respective pair of the discharging plate members 5 and the ejector plate members 6. Therefore, the device can be realized easily and inexpensively. Furthermore, the device is easy to disassemble and assemble, and maintenance work is facilitated.

### [Other Embodiments]

The present invention is not limited to embodiments such as the one described above, and a variety of variations or adjustments can be made without deviating from the scope of the present invention.

The positioning and/or configuration of the air intake part and/or ejector part are not limited by the aforementioned embodiment. For example, the air intake part and the ejector part can be positioned on only one side of the discharge part.

### [Key]

- 1.: Air intake part
- 2.: Ejector part
- 3.: Discharge part
- 5.: Discharging plate member
- 6.: Ejector plate member
- 12.: Joint (Air intake port)
- 14.: Air intake compartment
- 15.: Constricted part
- 16.: Air outflow part
- 18.: Discharge compartment
- 22.: Shim

Provided is a device capable of removing dust from a substrate surface with a simple and inexpensive configuration, and efficiently aspirating and disposing of the removed dust. The air dust collector is a device for removing dust from a substrate surface with air, having an air intake part (1) from where air is introduced, an ejector part (2), and a discharge part (3). The ejector part (2) increases the flow rate of the air from the air intake part (1) and blows the air onto the substrate surface. The discharge part (3) aspirates and discharges the air that has been blown out from the ejector part (2), as well as ambient air. The air pressure at the substrate surface is made lower than the ambient atmospheric pressure by the ejector effect produced by the air flowing from the ejector part (2) to the discharge part (3).

## Claims

1. An air dust collector for removing dust from a workpiece surface with air, comprising:
an air intake part from where air is introduced:
an ejector part for increasing the flow rate of the air from the air intake part and blowing the air onto the workpiece surface; and
a discharge part for aspirating and discharging the air that has been blown out from the ejector part, as well as ambient air;
wherein the air pressure at the workpiece surface is made lower than the ambient atmospheric pressure by an ejector effect produced by the air flowing from the ejector part to the discharge part.

2. The air dust collector of Claim 1, wherein the ejector part brings the air pressure at the workpiece surface to a negative pressure to an extent that the workpiece is not lifted up.

3. The air dust collector of Claim 1 or 2, wherein:
the air intake part has a pair of air intake ports positioned opposite each other, with the discharge part interposed in between; and
the ejector part has a pair of constricted parts positioned opposite each other, with the discharge part interposed in between, on the downstream side of an airflow pathway from the pair of air intake ports, which increases the flow rate of the air from the air intake ports, and further has a pair of air outflow parts positioned on the downstream side of an airflow pathway from the pair of constricted parts.

4. The air dust collector of Claim 3, wherein:
the discharge part has a pair of discharging plate members provided with an internally disposed discharge compartment and an aspiration port in communication with the discharge compartment at a lower end thereof;
the ejector part has a pair of ejector plate members respectively mounted on the outside of the pair of discharging plate members and arranged to form the constricted parts and the air outflow parts between the pair of ejector plate members and the pair of discharging plate members; and
a shim is further provided between the pair of discharging plate members and the pair of ejector plate members, for adjusting the cross-sectional area of the airflow pathway from the constricted parts.
